(19) Europäisches Patentamt / European Patent Office / Office européen des brevets

(11) **EP 4 716 050 A1**

(12) **EUROPEAN PATENT APPLICATION**

(43) Date of publication:
25.03.2026  Bulletin 2026/13

(21) Application number: 24201928.9

(22) Date of filing: 23.09.2024

(51) International Patent Classification (IPC):
$H02J\ 3/16^{(2026.01)}$   $H02J\ 3/18^{(2026.01)}$
$H02J\ 3/38^{(2026.01)}$   $H02M\ 1/32^{(2007.01)}$

(52) Cooperative Patent Classification (CPC):
H02J 3/381; H02J 3/16; H02J 3/1835; H02M 1/32;
H02M 1/325

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Friedrich-Alexander-Universität
Erlangen-Nürnberg,
in Vertretung des Freistaates Bayern
91054 Erlangen (DE)

(72) Inventors:
• KURI, Ananya
91052 Erlangen (DE)
• LUTHER, Matthias
91077 Dormitz (DE)

(74) Representative: Dr. Gassner & Partner mbB
Wetterkreuz 3
91058 Erlangen (DE)

(54) **METHOD AND DETERMINATION SECTION FOR DETERMINING A NOMINAL VOLTAGE MAGNITUDE VALUE, GRID-FORMING POWER CONVERTER, CORRESPONDING OPERATING METHOD AND COMPUTER PROGRAM PRODUCT**

(57)    Method (200) for determining a nominal voltage magnitude value for a control section (10) of a grid-forming power converter (1), the power converter (1) being configured to provide a multiphase AC voltage at an output terminal (4), the control section (10) being configured to generate setpoint values for the multiphase AC voltage based on phase restoring control, the method (200) comprising steps (202-205) of:
- Detecting an overcurrent event depending on a current information (18), the current information (18) representing measured instantaneous currents at the output terminal (4) of the power converter (1);

- Determining a reduction gain value depending on the current information (18) and a predefined reference current value;
- Determining, upon detecting the overcurrent event, the nominal voltage magnitude value as a function of an externally obtained voltage magnitude request value, the reduction gain value, a feedforward value and a feedback voltage value being a smoothed feedback voltage value, the feedback voltage value depending on a voltage information (19), which represents measured instantaneous voltage values of the multiphase AC voltage.

Fig. 1

EP 4 716 050 A1

**Description**

The present invention relates to a method for determining a nominal voltage magnitude value for a control section of a grid-forming power converter.

Besides, the present invention relates to a method for operating a grid-forming power converter, a determination section for determining a nominal voltage magnitude value for a control section of a grid-forming power converter, a grid-forming power converter and a computer program product.

The recent increase of renewable energy sources supplying electric power grids is a challenge for achieving reliability and stability of the grid since such energy sources lack a traditional rotating synchronous machine, which is capable of maintaining stability by its moment of inertia. Rather, renewable energy sources are connected to the grid by power converters, in particular inverters. Grid-forming power converters have been considered as a key technology for appropriately supporting the grid by responding to disturbances in order to restore voltage and frequency of the grid.

A promising approach for achieving grid-forming behavior of a power converter is the phase restoring principle, which is based on a change of perspective from converter to grid, prioritizing response to disturbance over response to setpoint changes and attaining nominal frequency in reverse action to conventional PLL-based approaches.

The article by A. Kuri et al., "Phase Restoring Principle: Concept of a novel grid-forming converter scheme," Power Supply Transformation - Grid Regulation and System Stability, 14. ETG/GMA-Symposium, Leipzig, Germany, 2022, pp. 1-6 discloses a grid-forming control scheme based on attaining nominal frequency.

The control concept generates a constant frequency and is achieved by an angular transformation of a $\rho_{dr}l_{dr}$ reference frame, which is defined by frequency drift as rotation angle of an $\alpha\beta$ reference. The resulting phase is emulated via a differentiator and is further smoothed. The differentiator discards a constant phase, thus, deriving instantaneous frequency. A resultant frequency drift is subtracted from a reference frequency and passed to a phase integrator. The integrator computes a linear part of the transformation angle used for cross-referencing an initial voltage magnitude and phase, which are transformed back from $p_{dr}l_{dr}$ to $\alpha\beta$ to derive a three-phase converter voltage.

Phase restoring control is further described in the articles by A. Kuri et al. "A novel Grid Forming Control Scheme Revealing a True Inertia Principle", in IEEE Transactions on Power Systems, vol. 36, no. 6, pp. 5369-5384, Nov. 2021; and by A. Kuri et al., "Power Dispatch Capacity of a Grid-Forming Control Based on Phase Restoring Principle," in IEEE Systems Journal, vol. 17, no. 3, pp. 3389-3400, Sept. 2023.

Nonetheless, a real grid-forming power converter based on semiconductor switching elements is not capable of showing an ideal voltage source behavior as current provided by the converter has to limited to an amount, where the switching elements do not suffer overload. Therefore, current limiting strategies for conventional types of grid-forming power converters have already been proposed, which serve to protect the switching elements and support the grid under severe symmetrical disturbances. Such strategies are, e.g., disclosed in the article by B. Fan et al. "A Review of Current-Limiting Control of Grid-Forming Inverters Under Symmetrical Disturbances," in IEEE Open Journal of Power Electronics, vol. 3, pp. 955-969, 2022.

It is an object of the present invention to provide an improved current limiting strategy capable of being used in a grid-forming power converter with phase restoring control.

The above object is solved by a method for determining a nominal voltage magnitude value for a control section of a grid-forming power converter, the power converter being configured to provide a multiphase AC voltage at an output terminal, the control section being configured to generate setpoint values for the multiphase AC voltage based on phase restoring control, the method comprising steps of: Detecting an overcurrent event depending on a current information , the current information representing measured instantaneous currents at the output terminal of the power converter; Determining a reduction gain value depending on the current information and a predefined reference current value; Determining, upon detecting the overcurrent event, the nominal voltage magnitude value as a function of an externally obtained voltage magnitude request value, the reduction gain value, a feedforward value and a feedback voltage value being a smoothed feedback voltage value, the feedback voltage value depending on a voltage information, which represents measured instantaneous voltage values of the multiphase AC voltage.

The invention is based upon the consideration to realize current limiting by limiting the magnitude of the nominal voltage magnitude value, therein allowing to keep the phase unaffected if an overcurrent event has been detected. That is, the externally obtained voltage magnitude request is processed so as to reduce the voltage provided by the grid-forming power converter for effectively limiting the current provided by the grid-forming power converter on the one hand and to for preserving phase-frequency coherence and original characteristics of phase restoring control on the other hand.

Thereto, the method according to the invention uses the feedforward value for determining the nominal voltage magnitude value for representing a coupling reactance between a power section of the converter and the output terminal, where measurement of the current information and the voltage information occurs. The reduction gain value represents the determined intended reduction of the voltage in response to the overcurrent event. By means of the smoothed feedback voltage value, the multiphase AC voltage at the output terminal approaches the measured voltages leading to a zero voltage drop across the coupling reactance after a decay of a natural response. Thus, there are two contributions from the current limitation strategy according to the invention: An active reduction and the feedback.

Advantageously, the proposed method for determining the nominal voltage magnitude value complies with the essential requirement of a grid-forming power converter, i.e., to maintain a constant magnitude and phase of the voltage within the transient time frame following a disturbance. A corresponding adjustment in the case of the overcurrent event is realized via scaling. If the voltage control bandwidths for regulation of the multiphase AC voltage are sufficiently small, the control loops' response time is slow, implying longer rise and settling times. Therein, the control must maintain stability under low short circuit ratio conditions and even form grid voltage when necessary. Thus, the determination of the nominal voltage magnitude value in conjunction with the phase restoring control allows to maintain voltage source behavior during severe disturbances. In case of deep faults, a reactive, viz. capacitive current is injected to stabilize the power system.

Values with the unit "pu" provided hereinafter refer to the per-unit system. Therein, a value of a physical quantity, in particular voltage, current or a derivative thereof, with the unit "pu" is a dimensionless value relative to a nominal value of the quantity.

Typically, the method is used for an electric grid with an operational voltage of at least 100 volts, preferably at least 200 volts, more preferably at least 1 kilovolt. Alternative or additionally, the effective value of the multiphase AC voltage may be at least 100 volts, preferably at least 200 volts, more preferably at least 1 kilovolt. Of course, the method can be in applications with an apparent power of at least 0.5 megavolt-ampere, preferably at least 1.0 megavolt-ampere. The frequency of the multiphase AC voltage may be 16 2/3 hertz, 50 hertz or 60 hertz.

In particular detail, the function may include determining a raw voltage magnitude value based on at least the voltage magnitude request value, the reduction gain value, the feedforward value and the feedback voltage value.

In a simplified implementation of the method, the raw voltage magnitude value may be used as nominal voltage magnitude value.

However, in a preferred implementation, the function may include determining, whether the raw voltage value exceeds a predefined voltage limit value and, upon detecting that the raw voltage value exceeds the voltage limit value, limiting the raw voltage value to the voltage limit value. The voltage limit value may be chosen to be between 1.05 to 1.5 pu, preferably 1.1 to 1.2 pu. The voltage limit value may be chosen in accordance with a grid code and a protection trip level.

Further, the raw voltage value may be determined by determining a product of the voltage magnitude request value, the reduction gain value and the feedforward value and by adding the feedback value to the product.

The smoothed feedback value may be determined by applying a filter with low pass characteristics to a magnitude of a voltage space vector derived from the voltage information. The voltage space vector may refer to the $p_{dr}|_{dr}$ coordinate system. The low pass characteristics may be PT1 characteristics. Therein, a time constant between 0.001 s and 0.1 s, preferably 0.005 s and 0.05 s, has been found experimentally to be appropriate.

Moreover, applying the filter may include to limit the feedback value to a predetermined upper limit and/or a predetermined lower limit. The limits may be considered as saturation limits. The lower limit may be zero. The upper limit may be 1.1 pu.

Preferably, the overcurrent event is detected, when a first set of predetermined conditions for the current information is satisfied.

The first set of predetermined conditions may include a sufficient condition that at least one of magnitudes of phase currents derived from the current information exceeds a predetermined upper limit. The predetermined upper limit may be between 1.05 and 1.25 pu, preferably between 1.12 and 1.17 pu.

The first set of predetermined conditions may include a (further) sufficient condition that a change over time of a magnitude of a current space vector derived from the current information exceeds a predetermined upper limit and a change over time of a magnitude of a voltage space vector derived from the voltage information undercuts a predetermined lower limit. That is, the changes over time must cumulatively exceed or undercut, respectively, the afore-said limits in order to satisfy the sufficient condition. The current space vector may refer to the $\alpha\beta$ coordinate systems. The voltage space vector may refer to the $p_{dr}|_{dr}$ coordinate system. The upper limit for the change of the magnitude of the current space vector may be between 0.0001 and 0.01 pu, preferably between 0.0005 and 0.005 pu. The lower limit for the magnitude of the change of the voltage space vector may be between 0.00001 and 0.001 pu, preferably between 0.00005 and 0.0005 pu.

According to a preferred implementation of the method according to the invention, upon detecting the overcurrent event, the step of determining the nominal voltage magnitude value is performed in a current limiting mode, wherein the method comprises a further step of: Detecting a mode change event depending on the current information. Upon detecting the mode change event, the step of determining the nominal voltage magnitude value may be performed in a steady-state mode, in which an instantaneous feedback value is used as feedback voltage value. That is, the steady-state mode refers to normal operating conditions of the grid-forming power converter, where no current limitation is necessary. In the steady-state mode, the nominal voltage magnitude value results from a superposition of the instantaneous voltage magnitude on the one hand and the feedforward value, the voltage magnitude request value and the reduction gain value on the other hand. Note that the reduction gain value is typically one in the steady-state mode.

Preferably, the mode change event is detected, when a second set of predetermined conditions for the current information is satisfied and the current limiting mode has been present for a predetermined time. Detecting the mode chance event may be implemented by a state machine, which may especially use a flip flop.

The second set of predetermined conditions may comprise the sufficient condition that all magnitudes of phase currents derived from the current information are below a predetermined lower limit. The lower limit may be greater than the upper limit of the first set of predetermined conditions. The lower limit may be between 1.01 and 1.1 pu, preferably between 1.03 and 1.07 pu. In particular, a range defined by the lower limit of 1.05 pu and the upper limit of 1.15 pu has been found experimentally to allow a slow development of the reactive current and, thus, voltage magnitude. However, these limits can be adapted to specific needs for the desired application.

Regarding the determination method according to the invention, the step of determining the reduction gain value may comprise: applying a filter with low pass characteristics to a magnitude of a current space vector derived from the current information and obtaining a filtered current information therefrom; applying the filtered current information to a proportional differentiator configured by the reference current value and followed by a counter to determine the reduction gain value. This allows to avoid the hunting effect as the method according to the invention does not use closed-loop current control.

The reference current value may be a nominal current value, therein allowing a rapid response if the current is below the lower limit and a slow reduction to bring the current back to its nominal value, if the current is above the upper limit.

The filter with low pass characteristics may have PT1 characteristics. In particular, the filter has a time constant between 0.001 s and 0.1 s, preferably between 0.005 and 0.05 s. The proportional differentiator may have a gain between 0.25 and 0.75 pu, preferably between 0.4 and 0.6 pu. The proportional differentiator may have a time constant between 0.005 s and 0.1 s, preferably between 0.01 s and 0.03 s.

Further, applying the filter with low pass characteristics to the current information may comprise to limit the filtered current information to a lower limit and/or to a higher limit. The lower limit may be between 0.2 and 1.0 pu, preferably between 0.6 and 0.8 pu. The upper limit may be between 1.0 and 1.5 pu, preferably between 1.1 and 1.2 pu.

The counter may be realized by a discrete integrator.

As already mentioned, several quantities derived from the voltage information and from the current information can be used in the above method. Thus, the method may comprise a further step of deriving current values from the current information and voltage values from the voltage information. The current values may comprise: magnitudes of measured phase currents; and/or current components in an $\alpha\beta$-coordinate system, obtained by a Clark transformation of the measured phase currents; and/or a complex current space vector in the $\alpha\beta$-coordinate system and its magnitude. The voltage values may comprise voltage components in an $\alpha\beta$-coordinate system, obtained by a Clark transformation of measured phase voltages; and/or a complex voltage space vector in the $\alpha\beta$-coordinate system and its magnitude; and/or voltage components in an $p_{dr}l_{dr}$-coordinate system, obtained by rotating the voltage components by an angle describing a phase drift; and/or a complex voltage space vector in the $p_{dr}l_{dr}$-coordinate system and its magnitude.

The above object is further solved by a method for operating a grid-forming power converter configured to provide a multiphase AC voltage at an output terminal, the power converter comprising a first control section, a second control section, and a power section comprising a plurality of semiconductor switching elements; the method comprising steps of: determining a nominal voltage magnitude value by carrying out the method described afore; generating, by the first control section, setpoint values for the multiphase AC voltage based on phase restoring control by using the determined nominal voltage magnitude value; and generating, by the second control section, control signals for switching the semiconductor switching elements so as to convert an input voltage into the multiphase AC voltage based on the setpoint values.

The method for operating the grid-forming power converter may comprise a step of measuring instantaneous current values at the output terminal and instantaneous voltage values of the multiphase AC voltage at the output terminal, therein providing the current information representing the measured instantaneous current values and the voltage information representing the measured instantaneous voltage values.

The above object is further solved by a determination section for determining a nominal voltage magnitude value for a control section of a grid-forming power converter, the power converter being configured to provide a multiphase AC voltage at an output terminal, the control section being configured to generate setpoint values for the multiphase AC voltage based on phase restoring control, wherein the determination section is configured to detect an overcurrent event depending on a current information, the current information representing measured instantaneous currents at the output terminal of the power converter; determine a reduction gain value depending on the current information and a predefined reference current value; determine, upon detecting the overcurrent event, the nominal voltage magnitude value as a function of an externally obtained voltage magnitude request value, the reduction gain value, a feedforward value and a feedback voltage value being a smoothed feedback voltage value, the feedback voltage value depending on a voltage information, which represents measured instantaneous voltage values of the multiphase AC voltage.

The above object is further solved by a grid-forming power converter configured to provide a multiphase AC voltage at an output terminal, the power converter comprising: a power section comprising a plurality of semiconductor switching elements; a determination section as described before; a first control section configured to generate setpoint values for the multiphase AC voltage based on phase restoring control by using the determined nominal voltage magnitude value; and a second control section; wherein the second control section is configured to generate control signals for switching the semiconductor switching elements so as to convert an input voltage into the multiphase AC voltage based on the setpoint values.

The grid-forming power converter according to the invention may comprise a measuring section configured to measure instantaneous current values at the output terminal and instantaneous voltage values of the multiphase AC voltage at the output terminal and to provide the current information representing the measured instantaneous current values and the voltage information representing the measured instantaneous voltage values.

The above object is further solved by a computer program product comprising instructions which, when the program is executed by a computer, cause the computer to carry out a the afore-said method for determining a nominal voltage magnitude value.

All statements regarding the method for determining a nominal voltage magnitude value apply analogously to the method for operating a grid-forming power converter, the determination section, the grid-forming power converter and the computer program product so that advantages described with regard to the method for determining a nominal voltage magnitude apply analogously to them.

Further details and advantages of the invention are disclosed in the following, wherein reference is made to the drawing. The drawings show schematically:

Fig. 1     a block diagram of an embodiment of a grid-forming power converter according to the invention;

Fig. 2     a block diagram of a first control section of the power converter shown in Fig. 1;

Fig. 3     a phasor diagram illustrating coordinate systems;

Fig. 4     a block diagram of an embodiment of a determination section according to the invention;

Fig. 5     a block diagram of a detection subsection of the determination section shown in Fig. 4;

Fig. 6     a block diagram of a first determination subsection of the determination section shown in Fig. 4;

Fig. 7     a block diagram of a second determination subsection of the determination section shown in Fig. 4; and

Fig. 8     a flow diagram of an embodiment of a method for operating a grid-forming power converter according to the invention including an embodiment of a method for determining a nominal voltage magnitude value according to the invention.

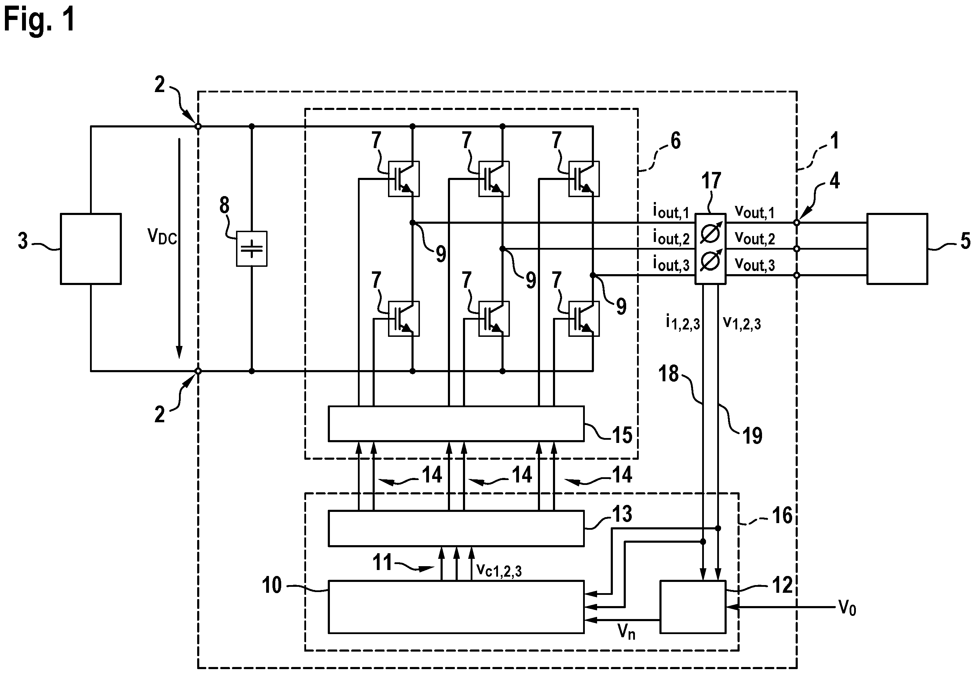

Fig. 1 is a block diagram of an embodiment of a grid-forming power converter 1.

The power converter 1 comprises an input terminal 2 configured to receive a DC input voltage $V_{DC}$. Exemplarily, Fig. 1 shows a DC voltage source 3 connected to the input terminal 2. The DC voltage source 3 may be an array of photovoltaic cells. At its output terminal 4, the power converter 1 is connected to an electric grid 5. The power converter 1 is configured to convert the input voltage $V_{DC}$ into a multiphase AC voltage at the output terminal 4, therein supplying the multiphase AC voltage into the grid 5. In the present embodiment the AC voltage is a three-phase AC voltage denoted by respective phase voltages $v_{out,1}$, $v_{out,2}$, $v_{out,3}$.

The power converter 1 comprises a power section 6, which comprises a plurality of semiconductor switching elements 7. As an exemplary implementation, the switching elements 7 are interconnected to one half-bridge for each phase of the multiphase AC voltage. The switching elements are connected via a DC link capacitor 8 to the input terminals 2. Respective taps between the switching elements 7 of each half-bridge are connected to the output terminal 4.

The power converter 1 further comprises a first control section 10, which is configured to generate setpoint values 11 denoted by $v_{c1}$, $v_{c2}$, $v_{c3}$ for the phase voltages $v_{out,1}$, $v_{out,2}$, $v_{out,3}$ based on phase restoring control. The first control section 10 is configured to generate the setpoint values 11 depending on a nominal voltage magnitude value $V_n$. The nominal voltage magnitude value $V_n$ is provided by an embodiment of a determination section 12 of the power converter 1. The determination section 12 is configured to determine the nominal voltage magnitude value $V_n$ based on an externally obtained voltage magnitude request value $V_0$, which may be provided by an operator of the electric grid 5.

A second control section 13 of the power converter 1 is configured to generate control signals 14 for switching the semiconductor switching elements 7 so as to convert the input voltage $V_{DC}$ into the multiphase AC voltage $v_1$, $v_2$, $v_3$ based on the setpoint values 11. Thereto, the second control section 13 may comprise a modulator to provide pulse-width modulated control signals 14 as generally known in the art. In particular detail, the control signal 14 are provided to a driver stage 15 of the power section 6, which converts the control signals into suitable control voltages for the switching elements 7.

Further, Fig. 1 shows a measuring device 17 of the power converter 1. The measuring device 17 is configured to measure the phase voltages $v_{out,1}$, $v_{out,2}$, $v_{out,3}$ and individual phase currents $i_{out,1}$, $i_{out,2}$, $i_{out,3}$ at the output terminal 4 of the power converter 1. The measuring device 17 provides a current information 18 representing the measured phase currents $i_1$, $i_2$, is and a voltage information 19 representing the measured phase voltages $v_1$, $v_2$, $v_3$.

The first and second control sections 10, 13 and the determination section 12 form part of a controller 16 of the power converter 1. The controller 16 may be implemented by a single piece or multiple pieces of hardware, such as a microcontroller, with suitable software running thereon. Thus, the indications "control sections" or "determination section" can be considered as functional divisions of such a controller 16.

Also, blocks shown in the following block diagrams do not have to be implemented by separated physical entities but serve merely for illustrating individual computational tasks. In the following, several blocks are used to describe the function of the embodiments. Therein,

- PT1 blocks represent a transfer function $H(s)=1/(1+s \cdot T_x)$,
- D blocks represent a transfer function $H(s)= s \cdot T_x$,
- I blocks represent a transfer function $H(s)=1/(s \cdot T_x)$,
- K blocks represent a transfer function $H(s)=K$,

wherein $T_x$ denotes a respective time constant of the block and K denotes a constant value. Further, several blocks represent manipulations of a respective complex number $\underline{z} = x+j \cdot y = r \cdot e^{j \cdot \varphi}$, j being the imaginary unit and e being Euler's number. Therein,

- $Re\{\underline{z}\} = x$ denotes real part of the complex number $\underline{z}$,
- $Im\{\underline{z}\} = y$ denotes an imaginary part of the complex number $z$,
- $|\underline{z}| = r$ denotes the magnitude of the complex number $z$ and
- $arg\{\underline{z}\} = \varphi = tan^{-1}(Im\{\underline{z}\}/Re\{\underline{z}\})$ denotes the argument of the complex number $\underline{z}$.

Further, several blocks represent forming an absolute value $|x|$ of a real number x.

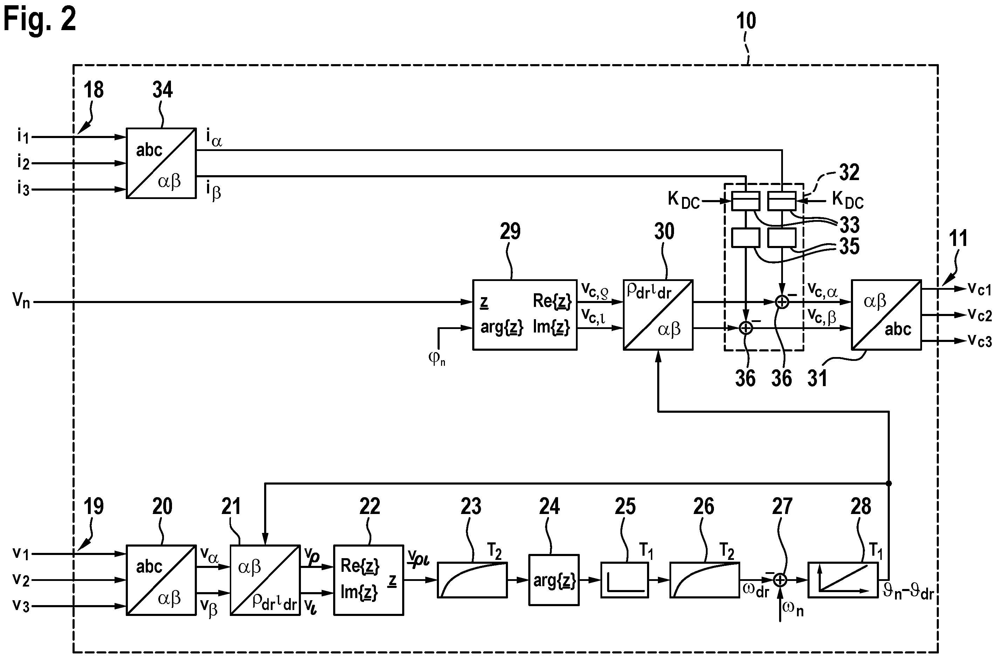

Fig. 2 is a block diagram of the first control section 10 of the power converter 1 shown in Fig. 1.

As mentioned before, the first control section 10 is configured to provide the setpoint values 11 based on phase restoring control or according to the phase restoring principle (PRP), respectively. In the following, for a better understanding, the basic concept of the PRP is outlined. Detailed information thereon can be found in the following articles, which are hereby incorporated by reference: A. Kuri et al., "Phase Restoring Principle: Concept of a novel grid-forming converter scheme," Power Supply Transformation - Grid Regulation and System Stability, 14. ETG/GMA-Symposium, Leipzig, Germany, 2022, pp. 1-6; A Kuri et al., "A novel Grid Forming Control Scheme Revealing a True Inertia Principle", in IEEE Transactions on Power Systems, vol. 36, no. 6, pp. 5369-5384, Nov. 2021; and A. Kuri et al., "Power Dispatch Capacity of a Grid-Forming Control Based on Phase Restoring Principle," in IEEE Systems Journal, vol. 17, no. 3, pp. 3389-3400, Sept. 2023.

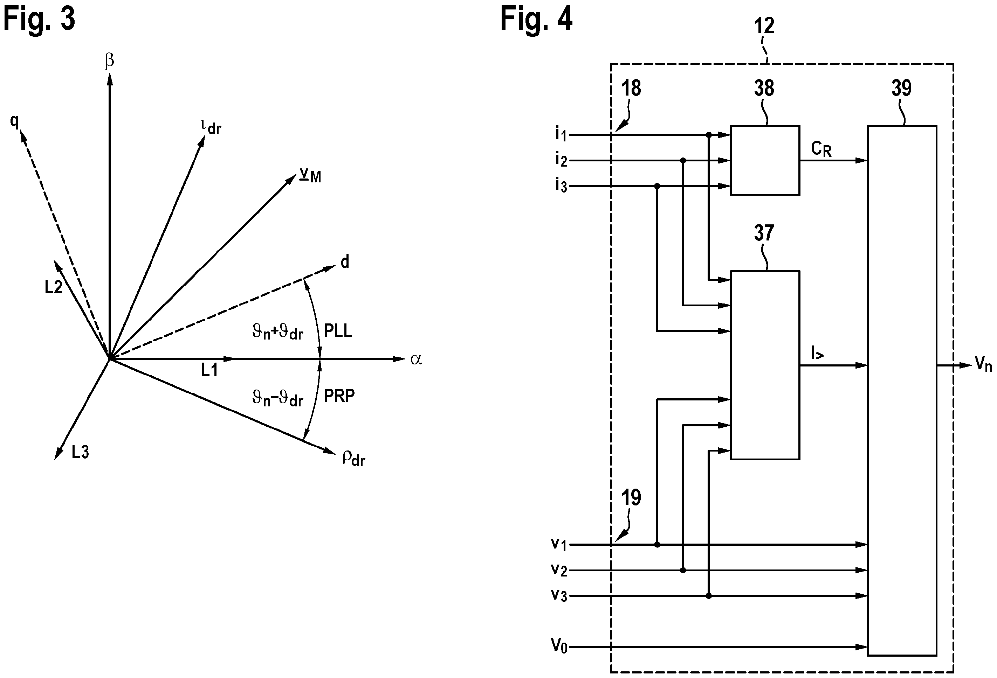

The PRP aims to achieve a constant steady state frequency by using an angular transformation to describe the multiphase AC voltage in a $p_{dr}$-$\iota_{dr}$ -coordinate system (where $\rho$ is the Greek letter rho and $\iota$ is the Greek letter iota). As illustrated in the phasor diagram shown in Fig. 3, in which L1, L2 and L3 denote the phases of the multiphase AC voltage and $\underline{v}_M$ denotes an arbitrary measured voltage given by trigonometric functions representation in an $\alpha\beta$-coordinate system, in the $p_{dr}\iota_{dr}$ frame, vectors $\rho_{dr}$ and $\iota_{dr}$ rotate contrary to a conventional rotating dq-coordinate system, which may be used for PLL based grid-forming techniques. That is, the components $\rho_{dr}$ and $\iota_{dr}$ are shifted against an $\alpha\beta$-coordinate system, which is obtained by a Clark transformation of the phases currents of phases L1, L2, L3, by an angle $\vartheta_n - \vartheta_{dr}$, which describes a phase drift in the grid 5. Contrary, PLL-based approaches follow the grid frequency or phase defined by $\vartheta_n + \vartheta_{dr}$. The transformation of voltage components $v_\alpha$, $v_\beta$ in the $\alpha\beta$-coordinate system into voltage $v_\rho$, $v_\iota$ in the $p_{dr}\iota_{dr}$ -coordinate system is given by:

$$\begin{bmatrix} v_\rho \\ v_\iota \end{bmatrix} = \begin{bmatrix} \cos(\vartheta_n - \vartheta_{dr}) & \sin(\vartheta_n - \vartheta_{dr}) \\ -\sin(\vartheta_n - \vartheta_{dr}) & \cos(\vartheta_n - \vartheta_{dr}) \end{bmatrix} \begin{bmatrix} v_\alpha \\ v_\beta \end{bmatrix}$$

in which $\underline{v}_M = v_\alpha + j \cdot v_\beta$ and $\underline{V}_{\rho\iota} = v_\rho + j \cdot v_\iota$ denote the complex space vectors.

PRP clamps the phase at the voltage measurement node, i.e., the position of the measuring device 17, restoring it to its initial value in the opposite direction to a disturbance in the ohmic-inductive network and achieving steady-state or constant frequency. It attains the post-disturbance operating point directly by adjusting the transformation angle applied to converter. The PRP represents the phase part of a voltage in grid-forming corresponding to a complex rotation and is a nonlinear phenomenon.

As shown in Fig. 2, the first control section 10 is configured to obtain the voltage information 19 and to transform the phase voltages $v_1$, $v_2$, $v_3$ contained therein into a complex space vector $\underline{V}_{\rho l} = v_\rho + j \cdot v_l$ the $p_{dr}l_{dr}$-coordinate system. In particular, the first control section in configured to transform the phase voltages $v_1$, $v_2$, $v_3$ by Clark transformation into voltage components $v_\alpha$, $v_\beta$ (as denoted by transformation block 20), to transform the voltage components $v_\alpha$, $v_\beta$ into voltage components $v_\rho$, $v_l$ in the $p_{dr}l_{dr}$-coordinate system by using a feedback phase drift angle $\vartheta_n - \vartheta_{dr}$ describing the phase drift (as denoted by transformation block 21) and to provide the complex voltage $\underline{V}_{\rho l}$ based on voltage components $v_\rho$, $v_l$ (as denoted by block 22). Further, the first control section 10 is configured smoothen the complex voltage $\underline{V}_{\rho l}$ by a transfer function having PT1 behavior (as denoted by PT1 block 23). Further, the first control section 10 is configured to determine a drift frequency $\omega_{dr}$ by smoothing a derivative of an argument of the smoothened complex value (as denoted by block 24, D block 25 and PT1 block 26). The first control section 10 is further configured to determine the phase drift angle $\vartheta_n - \vartheta_{dr}$ by integrating a difference of a normal frequency $\omega_n$ and the drift frequency $\omega_{dr}$ (as denoted by summation block 27 and I block 28).

The first control section 10 is configured to obtain the nominal voltage magnitude value $V_n$ and to transform voltage components $v_{c,\rho}$ $V_{c,l}$ in the $p_{dr}l_{dr}$-coordinate system determined from the nominal voltage magnitude value $V_n$ and a nominal voltage phase angle $\varphi_n$ into the setpoint values 11. Thereto, the first control section 10 generates the complex voltage $\underline{V}_{c,\rho l}$ from the nominal voltage magnitude value $V_n$ and the nominal voltage phase angle $\varphi_n$ (as denoted by block 29), transforms voltage components $v_{c,\rho}$ $V_{c,l}$ into the $\alpha\beta$-coordinate system (as denoted by transformation block 30) by using the on phase drift angle $\vartheta_n - \vartheta_{dr}$ and to transform voltage components $v_{c,\alpha}$, $v_{c,\beta}$ into the setpoint values $v_{c1}$, $v_{c2}$, $v_{c3}$ (as denoted by transformation block 31).

Optionally, the first control section comprises a DC compensation subsection 32 configured compensate DC components at the output terminal 17. Thereto, the DC compensation subsection 32 is configured to determine compensation values for the voltage components $v_{c,\alpha}$, $v_{c,\beta}$ by DC filtering the current information 18. In particular detail, the first control section 10 is configured to determine the compensation values by amplifying (as denoted by P block 33) current components $i_\alpha$, $i_\beta$ describing the phase currents $i_1$, $i_2$, $i_3$ in the $\alpha\beta$-coordinate system (as denoted by transformation block 34) and by DC filtering the amplified current components $K_a \cdot i_\alpha$, $K_a \cdot i_\beta$ (as denoted by filter blocks 35) and to substract the compensation values from the output of transformation block 30 (as denoted by summation blocks 36).

Fig. 4 is a block diagram of the determination section 12.

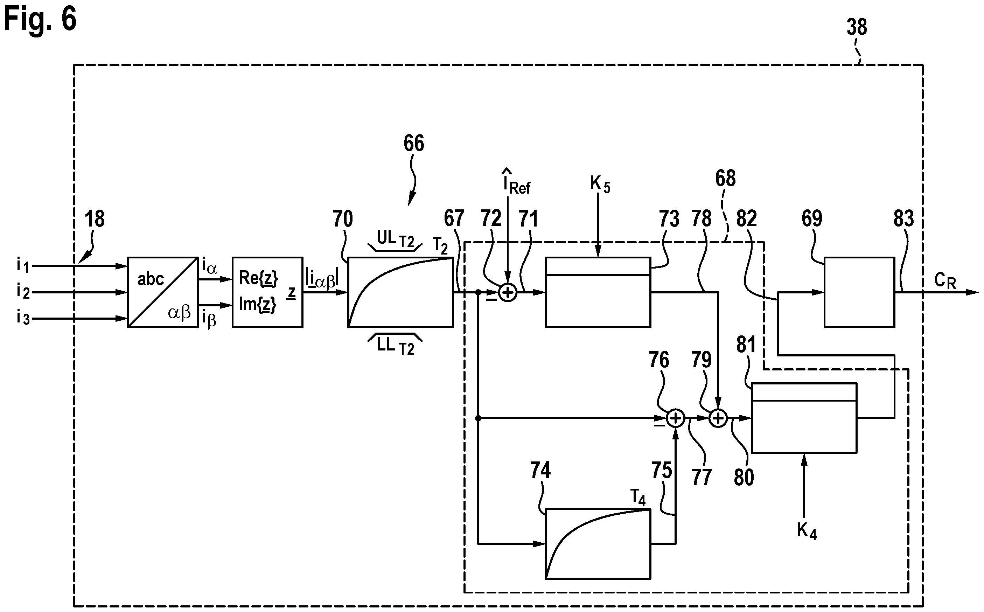

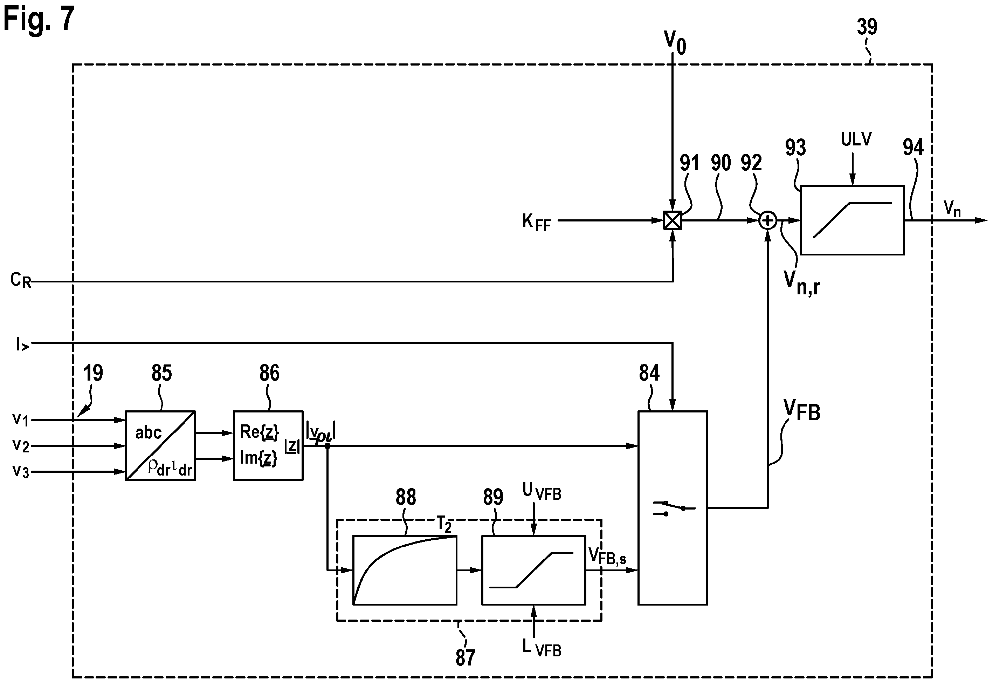

The determination section 12 comprises a detection subsection 37 configured to detect an overcurrent event depending on the current information 18 and the voltage information 19. In particular detail, the detection subsection 37 is configured to provide a detection signal $I_>$ upon detecting that the overcurrent event is present. Further, the determination section 12 comprises a first determination subsection 38 configured to determine a reduction gain value $C_R$ depending on the current information 18 and a predefined reference current value $\hat{I}_{ref}$ (see Fig. 6). Moreover, the determination section 12 comprises a second determination subsection 39, which is configured to determine, upon detecting the overcurrent event, the nominal voltage magnitude value $V_n$ as a function of the externally obtained voltage magnitude request value $V_0$, the reduction gain value $C_R$, a feedforward value $K_{FF}$ and a feedback voltage value $V_{FB}$ (see Fig. 7) depending on the voltage information 19.

In more detail, the determination section 12 is configured to be operated in a steady-state mode and in a current limiting mode. These modes are represented by a signal state of the detection signal $I_>$. Upon detecting a mode change event, the signal state of the detection signal $I_>$ changes correspondingly.

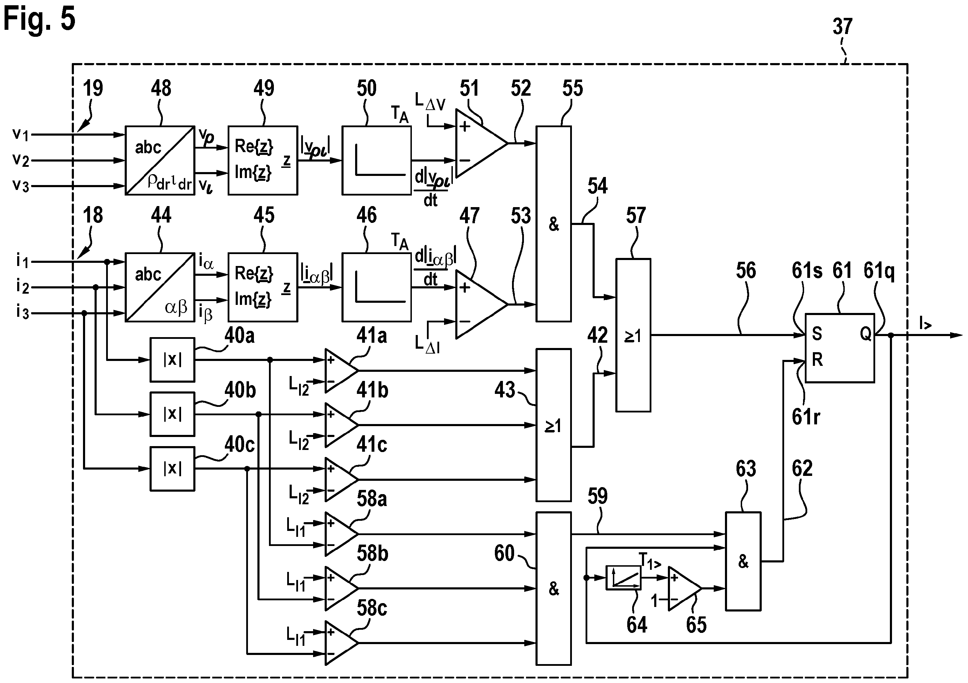

Fig. 5 is a block diagram of the detection subsection 37 of the detection section 12.

The detection section 37 is configured to determine the overcurrent event and to detect whether the mode change event occurs.

For determining the overcurrent event, the detection section 37 is configured to evaluate, whether a first set of predetermined conditions for the current information 18 and, optionally, of the voltage information 19 is satisfied.

The first set of predetermined conditions includes the sufficient condition that at least of one of the magnitudes $|i_1|$, $|i_2|$, $|i_3|$ of the phase currents $i_1$, $i_2$, is exceeds a predetermined upper limit $L_{I2}$. For evaluating the afore-said sufficient condition, the determination section 12 is configured to generate the magnitudes $|i_1|$, $|i_2|$, $|i_3|$ (as denoted by blocks 40a, 40b, 40c), to make a comparison with the predetermined upper limit $L_{I2}$ (as denoted by comparators 41a, 41b, 41c) and to provide a signal 42 if any of these comparisons results in that the magnitude exceeds the upper limit $L_{I2}$ (as denoted by OR block 43).

The first set of predetermined conditions includes a further sufficient condition that a change over time $d|\underline{i}_{\alpha\beta}|/dt$ of a magnitude $|\underline{i}_{\alpha\beta}|$ of a current space vector $\underline{i}_{\alpha\beta}$ exceeds a predetermined upper limit $L_{\Delta I}$ and a change over time $d|\underline{V}_{\rho l}|/dt$ of the magnitude $|\underline{V}_{\rho l}|$ of the voltage space vector $\underline{V}_{\rho l}$ undercuts a predetermined lower limit $L_{\Delta V}$. For evaluating the afore-said sufficient condition, the determination section 12 is configured to derive current components $i_\alpha$, $i_\beta$ of the current space

vector $i_{\alpha\beta}$ in the $\alpha\beta$-coordinate system (as denoted by transformation block 44 and block 45). The detection subsection 37 is configured to determine a derivative of the magnitude $|i_{\alpha\beta}|$ over time (as denoted by D block 46) and to make a comparison with the predetermined upper limit $L_{\Delta I}$ (as denoted by comparator 47). The voltage space vector $\underline{V}_{\rho I}$ may be obtained from the first control section 10 (see Fig. 2) and the detection subsection 37 is configured to determine its magnitude $|\underline{V}_{\rho I}|$ (see blocks 48, 49), to determine a derivative of the magnitude $|\underline{V}_{\rho I}|$ over time (as denoted by D block 50) and to make a comparison with the predetermined upper limit $L_{\Delta V}$ (as denoted by comparator 51). Therein, the transformation block 48 denotes a transformation of the phase voltages $v_1$, $v_2$, $v_3$ into components $v_\rho$, $v_I$ of the space vector $\underline{V}_{\rho I}$ in the $p_{dr}I_{dr}$ -coordinate system via a transformation of the phase voltages $v_1$, $v_2$, $v_3$ into the $\alpha\beta$-coordinate system in accordance with the transformation blocks 20, 21 shown in Fig. 2.

The detection section 37 is configured to provide signals 52, 53 as results of the respective comparisons and to provide a further signal 54 representing that change over time $d|i_{\alpha\beta}|/dt$ of a magnitude $|i_{\alpha\beta}|$ exceeds the upper limit $L_{\Delta I}$ and that the change over time $d|\underline{V}_{\rho I}|/dt$ of the magnitude $|\underline{V}_{\rho I}|$ of the voltage space vector $\underline{V}_{\rho I}$ undercuts the lower limit $L_{\Delta V}$ (denoted by AND block 55).

The determination section 37 is further configured to provide a signal 56 representing that any of the conditions in the first set is satisfied (denoted by OR block 57).

The detection subsection 37 is configured to detect the mode change event, when a second set of predetermined conditions for the current information 18 is satisfied and current limiting mode has been present for a predetermined time. The second set of predetermined conditions comprises the sufficient condition that all of the magnitudes $|i_1|$, $|i_2|$, $|i_3|$ of the phase currents $i_1$, $i_2$, $i_3$ are below a predetermined lower limit $L_{I1}$. For evaluating the afore-said sufficient condition, the determination section 12 is configured to make a comparison of each of the magnitudes $|i_1|$, $|i_2|$, $|i_3|$ with the predetermined lower limit Ln (as denoted by comparators 58a, 58b, 58c) and to provide a signal 59 if all of these comparisons result in that the magnitude exceeds the lower limit Ln (as denoted by AND block 60).

For detecting the mode change event, the detection subsection 37 implements a state machine based on a flip flop 61, in particular an RS flip flop, which provides the detection signal $I_>$ at its output 61q and the obtains the signal 56 at is set input 61s and a further signal 62 at its reset input 61r. For providing the reset signal 61r, the detection subsection is configured to evaluate, whether, cumulatively (as denoted by AND block 63), the second set of conditions is satisfied as indicated by the signal 59, the detection signal $I_>$ indicates presence of the current limiting mode and that the current limiting mode been present for the predetermined time (as denoted by integrator 64 and comparator 65).

Fig. 6 is a block diagram of the first determination subsection 38 of the determination section 12.

As already said, the first determination subsection 38 is configured to determine a reduction gain value $C_R$ depending on the current information 18 and a predefined reference current value $\hat{I}_{ref}$. Thereto, the first determination subsection 38 is configured to apply a filter 66 with low pass characteristics to the current information 18 and to obtain a filtered current information 67 therefrom. Further, the first determination subsection 38 is configured to apply the filtered current information 67 to a proportional differentiator 68 configured by the reference current value $\hat{I}_{ref}$ and followed by a counter 69 to determine the reduction gain value $C_R$.

In particular detail, the filter 66 is further configured to limit the filtered current information 67 to a lower limit $LL_{T2}$ and to a higher limit $UL_{T2}$ (as denoted by PT1 block 70).

As shown in more detail, the proportional differentiator 68 is configured to determine a difference 71 between the filtered current information 67 and the reference current value $\hat{I}_{ref}$ (as denoted by summation block 72) and to weigh the difference with a factor $K_5$ (as denoted by P block 73). The proportional differentiator 68 is further configured to low pass filter the filtered current information 67 (as denoted by PT1 block 74) and to subtract the filtered current information 67 from a value 75 determined by the low pass filtering (as denoted by summation block 76) resulting in a value 77. The weighted difference 78 is further added to value 77 (as denoted by summation block 79) and a sum 80 resulting therefrom is weighted with a factor $K_4$ (as denoted by P block 81).

Further, the first determination subsection 38 is configured to feed an output 82 of the proportional differentiator or the P block 81, respectively, to the counter 69, whose output 83 is the reduction gain value $C_R$. In detail, the output 82 is the sum 80 weighted by the factor $K_4$.

Fig. 7 is a block diagram of the second determination subsection 39 of the determination section 12 shown in Fig. 4.

The second determination subsection 39 is configured to determine the feedback voltage value $V_{FB}$ in two different ways depending on whether the steady-state mode or the current limiting mode is present according to a signal state of the detection signal $I_>$ (as denoted by switch block 84).

In both modes, the feedback voltage value $V_{FB}$ depends on the voltage information 19, in particular on the magnitude $|\underline{V}_{\rho I}|$. As already mentioned with regard to the detection subsection 37, the voltage space vector $\underline{V}_{\rho I}$ may be obtained from the first control section 10 (see Fig. 2) and the second determination subsection 39 is configured to

determine its magnitude $|\underline{V}_{\rho l}|$ (see blocks 85, 86). Of course, a common entity for determining the magnitude $|\underline{V}_{\rho l}|$ may be provided for use in the detection subsection 37 and the second determination subsection 39 so that the multiple blocks 48, 49, 85, 86 are shown separately for illustration purposes only.

In the steady-state mode, the second determination subsection 39 is configured to use an instantaneous feedback value being the magnitude $|\underline{V}_{\rho l}|$ as feedback value $V_{FB}$.

In the current limiting mode, the second determination subsection 39 is configured to determine the feedback voltage value $V_{FB}$ as smoothed feedback value $V_{FB,s}$ by applying a filter 87 with low pass characteristics to the voltage information (as denoted by PT1 block 88), which includes to limit the feedback value to a predetermined upper limit $U_{VFB}$ and a predetermined lower limit $L_{VFB}$ (as denoted by limiting block 89), therein implementing a non-windup first order smoothing functionality.

For determining the nominal voltage magnitude value $V_n$ as function of the voltage magnitude request value $V_0$, the reduction gain value $C_R$, the feedforward value $K_{FF}$ and the feedback voltage value $V_{FB}$, the function includes to determine a raw voltage magnitude value $V_{n,r}$ by determining a product 90 of the voltage magnitude request value $V_0$, the reduction gain value $C_R$ and the feedforward value $K_{FF}$ (as denoted by multiplication block 91) and by adding the feedback voltage value $V_{FB}$ to the product (as denoted by summation block 92).

Further, the function includes to determine, whether the raw voltage value $V_{n,r}$ exceeds a predefined voltage limit value ULV and, upon detecting that the raw voltage value $V_{n,r}$ exceeds the voltage limit value ULV, limiting the raw voltage value $V_{n,r}$ to the voltage limit value ULV (as denoted by limiting block 93). That is, an output 94 of the limiting block 93 forms the nominal voltage magnitude value $V_n$.

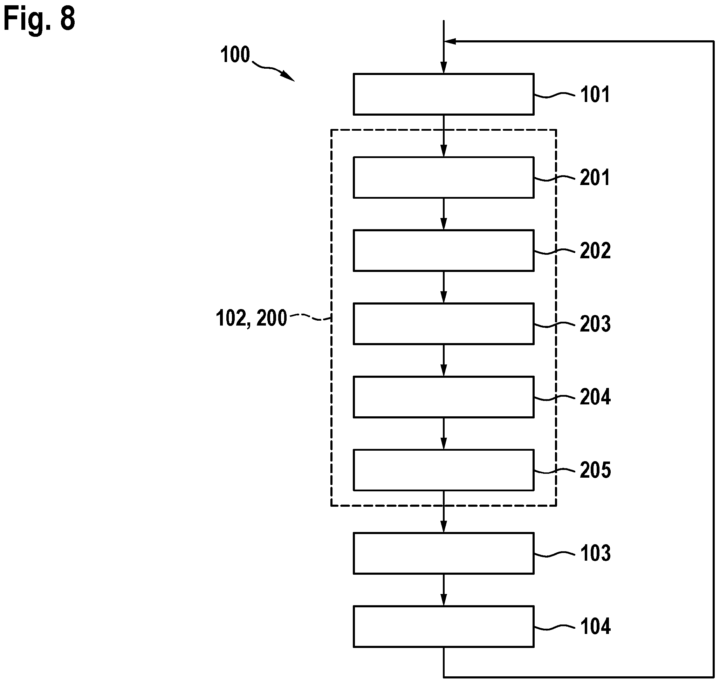

Fig. 8 is a flow diagram of an embodiment of a method 100 for operating a grid-forming power converter 1 including an embodiment of a method 200 for determining the nominal voltage magnitude value $V_n$.

Steps of the method 100 can be carried out by the grid-forming power converter 1 and steps of the method 200 can be carried out by the determination section 12. For illustration purposes, reference is made to the above embodiments. In particular, the sections and subsections are identified with respective steps of the methods 100, 200 so that statements regarding the above embodiments apply analogously to the steps of the methods 100, 200.

The grid-forming power converter 1 is configured to provide a multiphase AC voltage at an output terminal 4. The method 100 starts with a step 101 of measuring, in particular by the measuring device 17, instantaneous current values $i_{out,1}$, $i_{out,2}$, $i_{out,3}$ at the output terminal 4 and instantaneous voltage values of the multiphase AC voltage $v_{out,1}$, $v_{out,2}$, $v_{out,3}$ at the output terminal 4 and to provide a current information 18 representing the measured instantaneous current values $i_1$, $i_2$, is and a voltage information 19 representing the measured instantaneous voltage values $v_1$, $v_2$, $v_3$.

As further step 102, the method 100 carries out the steps of the method 200 to determine, in particular by the determination section 12, a nominal voltage magnitude value $V_n$ as described in further detail below.

The method 200 comprises a step 201 of deriving current values from the current information 18 and voltage values from the voltage information 19. The current values comprise:

- magnitudes $|i_1|$, $|i_2|$, $|i_3|$ of measured phase currents $i_1$, $i_2$, is;
- current components $i_\alpha$, $i_\beta$ in an $\alpha\beta$-coordinate system, obtained by a Clark transformation of the measured phase currents $i_1$, $i_2$, is; and
- a complex current space vector $\underline{i}_{\alpha\beta}$ in the $\alpha\beta$-coordinate system and its magnitude $|\underline{i}_{\alpha\beta}|$.

The voltage values comprise:

- voltage components $v_\alpha$, $v_\beta$ in an $\alpha\beta$-coordinate system, obtained by a Clark transformation of measured phase voltages $v_1$, $v_2$, vs;
- a complex voltage space vector $\underline{v}_{\alpha\beta} = v_\alpha + j \cdot v_\beta$ in the $\alpha\beta$-coordinate system and its magnitude $|\underline{v}_{\alpha\beta}|$;
- voltage components $v_\rho$, $v_l$ in an $p_{dr}l_{dr}$-coordinate system, obtained by rotating the voltage components $v_\alpha$, $v_\beta$ by an angle $\vartheta_n - \vartheta_{dr}$ describing a phase drift of a grid 5; and
- a complex voltage space vector $\underline{V}_{\rho l} = v_\rho + j \cdot v_l$ in the $p_{dr}l_{dr}$-coordinate system and its magnitude $|\underline{V}_{\rho l}|$.

The method 200 comprises a step 202 of detecting, in particular by the detection subsection 37 (see Fig. 5), an overcurrent event depending on the current information 18. The overcurrent event is detected, when a first set of predetermined conditions is satisfied. The first set of predetermined conditions includes the sufficient condition that at least one the magnitudes of the phase currents $|i_1|$, $|i_2|$, $|i_3|$ exceeds a predetermined upper limit $L_{I2}$. Further, the first set of predetermined conditions includes the sufficient condition that, cumulatively, a change over time of the magnitude of the current space vector $d|\underline{i}_{\alpha\beta}|/dt$ exceeds a predetermined upper limit $L_{\Delta I}$ and a change over time of the magnitude of the voltage space vector $d|\underline{V}_{\rho l}|/dt$ undercuts a predetermined lower limit $L_{\Delta V}$.

The step 202 further includes providing a signal 56 representing that any of the conditions in the first set is satisfied.

The method 200 comprises a step 203 of determining, in particular by the first determination subsection 38 (see Fig. 6), a reduction gain value $C_R$ depending on the current information 18 and a predefined reference current value $\hat{I}_{ref}$. In particular, this step includes to apply a filter 66 with low pass characteristics to the magnitude of the current space vector $|i_{\alpha\beta}|$, therein limiting the filtered current information to a lower limit $LL_{T2}$ and to an upper limit $UL_{T2}$, and to obtain a filtered current information 67 therefrom. Further, the step 203 includes to apply the filtered current information 67 to a proportional differentiator 68 configured by the reference current value $\hat{I}_{ref}$ and followed by a counter 69 to determine the reduction gain value $C_R$.

In more detail, the step 203 includes to determine, by the proportional differentiator 68, a difference 71 between the filtered current information 67 and the reference current value $\hat{I}_{ref}$ and to weigh the difference with a factor Ks, therein obtaining a weighted difference 78. Further, 203 includes low pass filtering, by the proportional differentiator 68, the filtered current information 67 and subtracting the filtered current information 67 from a value 75 obtained by the low pass filtering resulting in a value 77. Further, step 203 includes adding the weighted difference 78 to the value 77 and weighting a sum 80 resulting therefrom with a factor $K_4$.

In further detail, step 203 includes feeding an output 82 to the counter 69, whose output 83 is the reduction gain value $C_R$. In detail, the output 82 is the sum 80 weighted by the factor $K_4$.

The method 200 further comprises a step 204 of determining, in particular by the second determination subsection 39 the nominal voltage magnitude value as a function of an externally obtained voltage magnitude request value $V_0$, the reduction gain value $C_R$, a feedforward value $K_{FF}$ and a feedback voltage value $V_{FB}$. The feedback voltage value $V_{FB}$ depends on the voltage information 19.

In a steady-state mode, an instantaneous feedback value is used as feedback voltage value $V_{FB}$. Here, the magnitude of the voltage space vector $|\underline{V}_{\rho\iota}|$ in the $\rho_{dr}\iota_{dr}$ -coordinate system is used as instantaneous feedback value.

In a current limiting mode being present upon detection of the overcurrent event, a smoothed feedback value $V_{FB,s}$ is used as feedback voltage value. Thereto, the step 204 includes applying a filter 87 with low pass characteristics to the magnitude of the voltage space vector $|\underline{V}_{\rho\iota}|$, which includes limiting the feedback voltage value $V_{FB}$ to a predetermined upper limit $U_{VFB}$ and a predetermined lower limit $L_{VFB}$. In the present embodiment, the low pass characteristics are PT1 characteristics. Therein, presence of the current limiting or the stead-state mode is determined by evaluating a detection signal $I_>$.

The above-mentioned function includes determining a raw voltage magnitude value $V_{n,r}$ by determining a product of the voltage magnitude request value $V_0$, the reduction gain value $C_R$ and the feedforward value $V_{FF}$ and by adding the feedback value $V_{FB}$ to the product.

Further, the function includes determining, whether the raw voltage value $V_{n,r}$ exceeds a predefined voltage limit value ULV and, upon detecting that the raw voltage value $V_{n,r}$ exceeds the voltage limit value ULV, limiting the raw voltage value $V_{n,r}$ to the voltage limit value ULV. Then, the limited raw voltage value $V_{n,r}$ is used as voltage magnitude value $V_n$.

According to an alternative embodiment, the raw voltage value $V_{n,r}$ is used as voltage magnitude value $V_n$, i.e. limiting the raw voltage value $V_{n,r}$ is omitted.

The method 200 comprises a further step 205 of detecting, in particular by the first determination subsection 37 (see Fig. 5), a mode change event depending on the current information 18. Upon detecting, the mode change event, step 204 is performed in the steady-state, when it has been in the current limiting mode priorly.

The mode change event is detected, when a second set of predetermined conditions for the current information is satisfied and current limiting mode has been present for a predetermined time.

The second set of predetermined conditions comprises the sufficient condition that all of the magnitudes $|i_1|$, $|i_2|$, $|i_3|$ of the phase currents $i_1$, $i_2$, is are below a predetermined lower limit $L_{I1}$. For evaluating the afore-said sufficient condition, the step 205 includes comparing each of the magnitudes $|i_1|$, $|i_2|$, $|i_3|$ with the predetermined lower limit $L_{I1}$ and providing a signal 59 if all of these comparisons results in that the magnitude exceed the lower limit $L_{I1}$.

Further, the step 205 includes using a state machine implemented by a flip flop 61, which provides the detection signal $I_>$ at its output 61q, obtains the signal 56 at its set input 61s and a further signal 62 at its reset input 61r. For providing the reset signal 61r, the step 205 includes to evaluate, whether the second set of conditions is satisfied as indicated by the signal 59, and whether the detection signal $I_>$ indicates that the current limiting mode has been present for the predetermined time.

The method 200 is carried out iteratively so that the result of the step 205 configures the step 204 to be carried out in the steady-state mode or in the current limiting mode at its subsequent occurrence.

The method 100 comprises a further step 102 of generating, by the first control section 10, setpoint values $v_{c1}$, $v_{c2}$, $v_{c3}$ for the multiphase AC voltage based on phase restoring control by using the determined nominal voltage magnitude value $V_n$.

The method 100 comprises a further step 103 of generating, by the second control section 13, control signals 14

for switching the semiconductor switching elements 7 so as to convert an input voltage $V_{DC}$ into the multiphase AC voltage based on the setpoint values $v_{c1}$, $v_{c2}$, $v_{c3}$.

The steps of the method 100 are carried out repeatedly, therein also repeating the steps of the method 200 as already mentioned.

The following table parameters according to an exemplary configuration of the embodiments of the power converter 1, the determination section 12 and the methods 100, 200. Of course, the parameters can be adapted to the specific implementation of these embodiments and serve to illustrate a specific mode to carry out the invention only:

| Block | Parameter | Value | Unit |
|---|---|---|---|
| D block 25, I block 28 | $T_1$ | $1.0/(50 \cdot 2\pi)$ | s |
| PT1 block 23, PT1 block 26, PT1 block 70, PT1 block 88 | $T_2$ | 0.01 | s |
| P blocks 33 | $K_{DC}$ | 0.02 | s |
| Comparator blocks 41a-c | $L_{I2}$ | 1.15 | pu |
| D blocks 46, 50 | $T_A$ | $10^{-4}$ | s |
| Comparator block 47 | $L_{\Delta I}$ | 0.001 | pu |
| Comparator block 51 | $L_{\Delta V}$ | 0.0001 | pu |
| Comparator blocks 58a-c | $L_{I1}$ | 1.05 | pu |
| I block 64 | $T_{1>}$ | 0.001 | s |
| PT1 block 70 | $UL_{T2}$ | 1.15 | pu |
| PT1 block 70 | $LL_{T2}$ | 0.7 | pu |
| P block 73 | $K_5$ | 0.5 | pu |
| PT1 block 74 | $T_4$ | 0.02 | s |
| P block 81 | $K_4$ | 0.005 | pu |
| Limiting block 89 | $U_{VFB}$ | 1.1 | pu |
| Limiting block 89 | $L_{VFB}$ | 0 | pu |
| Multiplication block 91 | $K_{FF}$ | 0.1 | pu |
| Limiting block 93 | ULV | 1.15 | pu |

In the above table, the unit "s" denotes seconds and "pu" the unit of the per-unit-system. Values with the unit "pu" refer to the per-unit system, in which a value of a physical quantity is dimensionless and express relative to a nominal value of the quantity.

**Claims**

1. Method (200) for determining a nominal voltage magnitude value for a control section (10) of a grid-forming power converter (1), the power converter (1) being configured to provide a multiphase AC voltage at an output terminal (4), the control section (10) being configured to generate setpoint values for the multiphase AC voltage based on phase restoring control, the method (200) comprising steps (202-205) of:

   - Detecting an overcurrent event depending on a current information (18), the current information (18) representing measured instantaneous currents at the output terminal (4) of the power converter (1);
   - Determining a reduction gain value depending on the current information (18) and a predefined reference current value; and
   - Determining, upon detecting the overcurrent event, the nominal voltage magnitude value as a function of an externally obtained voltage magnitude request value, the reduction gain value, a feedforward value and a feedback voltage value being a smoothed feedback voltage value, the feedback voltage value depending on a voltage information (19), which represents measured instantaneous voltage values of the multiphase AC voltage.

2. Method according to claim 1, wherein the function includes determining a raw voltage magnitude value based on at least the voltage magnitude request value, the reduction gain value, the feedforward value and the feedback voltage value.

3. Method according to claim 2, wherein the function includes determining, whether the raw voltage value exceeds a predefined voltage limit value and, upon detecting that the raw voltage value exceeds the voltage limit value, limiting the raw voltage value to the voltage limit value.

4.  Method according to claim 2 or 3, wherein the raw voltage value is determined by determining a product of the voltage magnitude request value, the reduction gain value and the feedforward value and by adding the feedback value to the product.

5.  Method according to any of the preceding claims, wherein the smoothed feedback value is determined by applying a filter (87) with low pass characteristics to a magnitude of a voltage space vector derived from the voltage information.

6.  Method according to claim 5, wherein applying the filter (87) includes to limit the feedback value to a predetermined upper limit and/or a predetermined lower limit.

7.  Method according to any of the preceding claims, wherein the overcurrent event is detected, when a set of predetermined conditions for the current information (18) is satisfied, wherein the set of predetermined conditions includes

     - a sufficient condition that at least one of magnitudes of phase currents derived from the current information exceeds a predetermined upper limit; and/or
     - a sufficient condition that

        (i) a change over time of a magnitude of a current space vector derived from the current information exceeds a predetermined upper limit and
        (ii) a change over time of a magnitude of a voltage space vector derived from the voltage information undercuts a predetermined lower limit.

8.  Method according to any of the preceding claims, wherein upon detecting the overcurrent event, the step (204) of determining the nominal voltage magnitude value is performed in a current limiting mode, wherein the method comprises a further step (205) of:

     - Detecting a mode change event depending on the current information;

     wherein upon detecting the mode change event, the step (204) of determining the nominal voltage magnitude value is performed in a steady-state mode, in which an instantaneous feedback value is used as feedback voltage value.

9.  Method according to claim 8, wherein the mode change event is detected, when a second set of predetermined conditions for the current information is satisfied and the current limiting mode has been present for a predetermined time, wherein the second set of predetermined conditions comprises the sufficient condition that all magnitudes of phase currents derived from the current information are below a predetermined lower limit.

10. Method according to any of the preceding claims, wherein
    the step (203) of determining the reduction gain value comprises:

     - applying a filter (66) with low pass characteristics to a magnitude of a current space vector derived from the current information (18) and obtaining a filtered current information therefrom;
     - applying the filtered current information to a proportional differentiator (68) configured by the reference current value and followed by a counter (69) to determine the reduction gain value.

11. Method according to claim 10, wherein
    applying the filter (66) with low pass characteristics to the current information comprises to limit the filtered current information to a lower limit and/or to a higher limit.

12. Method (100) for operating a grid-forming power converter (1) configured to provide a multiphase AC voltage at an output terminal (4), the power converter comprising

     - a first control section (10),
     - a second control section (13), and
     - a power section (6) comprising a plurality of semiconductor switching elements (7);

the method (100) comprising steps (102-104) of:

- determining a nominal voltage magnitude value by carrying out a method (200) according to any of the preceding claims;
- generating, by the first control section (10), setpoint values for the multiphase AC voltage based on phase restoring control by using the determined nominal voltage magnitude value; and
- generating, by the second control section (13), control signals (14) for switching the semiconductor switching elements (7) so as to convert an input voltage into the multiphase AC voltage based on the setpoint values.

13. Determination section (12) for determining a nominal voltage magnitude value for a control section (10) of a grid-forming power converter (1), the power converter (1) being configured to provide a multiphase AC voltage at an output terminal (4), the control section (10) being configured to generate setpoint values for the multiphase AC voltage based on phase restoring control, wherein the determination section (12) is configured to

- detect an overcurrent event depending on a current information (18), the current information (18) representing measured instantaneous currents at the output terminal (4) of the power converter;
- determine a reduction gain value depending on the current information (18) and a predefined reference current value; and
- determine, upon detecting the overcurrent event, the nominal voltage magnitude value as a function of an externally obtained voltage magnitude request value, the reduction gain value, a feedforward value and a feedback voltage value being a smoothed feedback voltage value, the feedback voltage value depending on a voltage information (19), which represents measured instantaneous voltage values of the multiphase AC voltage.

14. Grid-forming power converter (1) configured to provide a multiphase AC voltage at an output terminal (4), the power converter (1) comprising:

- a power section (6) comprising a plurality of semiconductor switching elements (7);
- a determination section (12) according to claim 13;
- a first control section (10) configured to generate setpoint values for the multiphase AC voltage based on phase restoring control by using the determined nominal voltage magnitude value; and
- a second control section (13);

wherein the second control section (13) is configured to generate control signals (14) for switching the semiconductor switching elements (7) so as to convert an input voltage into the multiphase AC voltage based on the setpoint values.

15. Computer program product comprising instructions which, when the program is executed by a computer, cause the computer to carry out a method (200) according to any of claims 1 to 11.

**Fig. 1**

**Fig. 2**

Fig. 4

Fig. 3

16

Fig. 5

**Fig. 6**

EP 4 716 050 A1

Fig. 7

**Fig. 8**

EP 4 716 050 A1

Europäisches
Patentamt

European
Patent Office

Office européen
des brevets

# EUROPEAN SEARCH REPORT

**Application Number**

EP 24 20 1928

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | A. KURI ET AL.: "Phase Restoring Principle: Concept of a novel grid-forming converter scheme", POWER SUPPLY TRANSFORMATION - GRID REGULATION AND SYSTEM STABILITY, vol. 14, 2022, pages 1-6, XP002813010, * the whole document * | 1-15 | INV. H02J3/16 H02J3/18 H02J3/38 H02M1/32 |
| A,D | KURI ANANYA ET AL: "A Novel Grid Forming Control Scheme Revealing a True Inertia Principle", IEEE TRANSACTIONS ON POWER SYSTEMS, IEEE, USA, vol. 36, no. 6, 6 April 2021 (2021-04-06), pages 5369-5384, XP011884453, ISSN: 0885-8950, DOI: 10.1109/TPWRS.2021.3071126 [retrieved on 2021-10-18] * the whole document * | 1-15 | |
| A,D | KURI ANANYA ET AL: "Power Dispatch Capacity of a Grid-Forming Control Based on Phase Restoring Principle", IEEE SYSTEMS JOURNAL, IEEE, US, vol. 17, no. 3, 1 September 2023 (2023-09-01), pages 3389-3400, XP011947724, ISSN: 1932-8184, DOI: 10.1109/JSYST.2022.3229103 [retrieved on 2022-12-30] * the whole document * | 1-15 | **TECHNICAL FIELDS SEARCHED (IPC)** H02J H02M |
| A,D | B. FAN ET AL.: "A Review of Current-Limiting Control of Grid-Forming Inverters Under Symmetrical Disturbances", IEEE OPEN JOURNAL OF POWER ELECTRONICS, vol. 3, 2022, pages 955-969, XP002813011, * the whole document * | 1-15 | |

The present search report has been drawn up for all claims

| Place of search | Date of completion of the search | Examiner |
|---|---|---|
| Munich | 14 February 2025 | Krasser, Bernhard |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
 
& : member of the same patent family, corresponding
    document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. KURI et al.** Phase Restoring Principle: Concept of a novel grid-forming converter scheme. *Power Supply Transformation - Grid Regulation and System Stability, 14. ETG/GMA-Symposium, Leipzig, Germany*, 2022, 1-6
- **A. KURI et al.** A novel Grid Forming Control Scheme Revealing a True Inertia Principle. *IEEE Transactions on Power Systems*, November 2021, vol. 36 (6), 5369-5384

- **A. KURI et al.** Power Dispatch Capacity of a Grid-Forming Control Based on Phase Restoring Principle. *IEEE Systems Journal*, September 2023, vol. 17 (3), 3389-3400
- **B. FAN et al.** A Review of Current-Limiting Control of Grid-Forming Inverters Under Symmetrical Disturbances. *IEEE Open Journal of Power Electronics*, 2022, vol. 3, 955-969
- **A KURI et al.** A novel Grid Forming Control Scheme Revealing a True Inertia Principle. *IEEE Transactions on Power Systems*, November 2021, vol. 36 (6), 5369-5384